# EUROPEAN PATENT APPLICATION

(11) **EP 3 616 815 A1**
(43) Date of publication of application: **04.03.2020**
(21) Application number: 18786202.4
(22) Date of filing: 18.09.2018
(51) Int. Cl.: B23D 33/02, B23D 15/04

(54) **SUBSTRATE MATERIAL CUTTING DEVICE**

(30) Priority: 22.06.2018 CN 201820969087 U
(71) Applicant: Miasolé Equipment Integration (Fujian) Co., Ltd., 362005 Quanzhou Fujian (CN)
(72) Inventor: The designation of the inventor has not yet been filed
(74) Representative: Cabinet Beau de Loménie
(86) International application number: PCT/CN2018/106141
(87) International publication number: WO 2019/242129

(57) **Abstract**

The present disclosure relates to an apparatus for cutting substrate material, the apparatus including: a mounting frame (1); a base (2) mounted to the mounting frame (1); an upper cutter device (3) disposed on the mounting frame (1); and a substrate material clamp (6) disposed on the upper cutter device (3) and used to clamp substrate material, the substrate material clamp (6) including a clamp body (6-2) and a flattening member(6-1) connected to the clamp body, and the flattening member (6-1) being used to flatten the substrate material. In the above technical solution, the flattening member is provided on the lower surface of the substrate material clamp, and during the process that the substrate material clamp approaches the base, the flattening member flattens the curled substrate material, and thus the quality of the substrate material is improved.

## Description

### TECHNICAL FIELD

The present application relates to the technical field of cutting machinery apparatus, and more particularly, to an apparatus for cutting substrate material.

### BACKGROUND

### The introduction of related art

The process pipeline of a substrate material, such as a substrate material of a battery chip, is as follows: at first, the substrate material is coated with a film in a coating machine, and then the substrate material after coating is cut to a predetermined size. Since heating is required for coating in the coating machine, and the substrate material is very thin, the substrate material after coating is liable to curl. At present, a cutting machine is used for cutting the substrate material on the market. The clamp in the existing cutting machine generally employs an aluminum alloy plate, and a rubber bar is provided on the depression surface of the aluminum alloy plate for alleviating the impact force. During cutting the substrate material, when the substrate material is conveyed to the cutting machine for a predetermined length, on the one hand, the substrate material is heated in the previous process, which causes the substrate material itself to curl; and on the other hand, the cutting machine that has been working all the time generates vibration and the vibration is transferred to the clamp to cause the substrate material to vibrate, then a wrinkle occurs at a pressed portion of the substrate material when the substrate material is pressed and cut by the clamp. In addition, under the influence of the rubber bar on the lower surface of the aluminum alloy plate, the substrate material pressed and cut by the clamp is bent or has an indentation on its pressed portion, which affects the power generation performance of the substrate material and the subsequent processing of the battery material.

### SUMMARY

### (1) Purpose

The purpose of the present disclosure is to provide an apparatus for cutting substrate material. By setting a flattening member, the clamp generates an outward force at both ends in contact with the substrate material during the pressing process to flatten the substrate material, thereby solving the problems that in the coating process of the substrate material, the edge of the substrate material having a relatively thin thickness is curled due to the high temperature, and if the curled substrate material is directly cut, the curled substrate material is prone to wrinkle when the clamp is directly pressed down.

### (2)Technical solutions

In order to solve the above problems, a first aspect of the present disclosure provides an apparatus for cutting substrate material, including: a mounting frame; a base mounted to the mounting frame; an upper cutter device disposed on the mounting frame; and a substrate material clamp disposed on the upper cutter device and used to clamp the substrate material, the substrate material clamp including a clamp body and a flattening member connected to the clamp body, and the flattening member being used to flatten the substrate material.

Optionally, the flattening member includes a first flattening member and a second flattening member; the first flattening member and the second flattening member are movably connected, and a joint of the first flattening member and the second flattening member is connected to the clamp body.

Optionally, the first flattening member and the second flattening member are arc-shaped.

Optionally, inner sides of the first flattening member and the second flattening member are set as a linear shape.

Optionally, the first flattening member and the second flattening member are respectively provided with a rough inner surface.

Optionally, the flattening member includes at least one flattening layer having elasticity.

Optionally, the flattening member includes a first flattening layer and a second flattening layer connected to each other; and the second flattening layer faces the base.

Optionally, a distance between a lowest end of the flattening member and an upper surface of the base is 20-25 mm, and a distance between the joint of the flattening member and the upper surface of the base is 120-125 mm.

Optionally, both ends of the flattening member are extendable outward by 10-20 mm, respectively.

Optionally, the apparatus for cutting substrate material further includes: a driving member connected to the upper cutter device, and the upper cutter device and substrate material clamp are driven by the driving member to approach or away from the base.

Optionally, the apparatus for cutting substrate material further includes: a lower cutter device; the lower cutter device is disposed on the base and is opposite to the upper cutter device; and the driving member drives the upper cutter device to approach or away from the lower cutter device.

Optionally, a length of the joint is 100-200 mm.

Optionally, entire bodies of the first flattening member and the second flattening member or ends of the first flattening member and the second flattening member are made of an elastic material.

Optionally, lengths of the arcs of the first flattening member and the second flattening member are both 400-500 mm.

Optionally, lengths of the first flattening member and the second flattening member are both 495-500 mm.

### Summary of technical solutions

During usage, the substrate material is heated and coated in the coating machine and then directly conveyed to the apparatus for cutting substrate material for cutting. When the substrate material is transported to the base and reaches a predetermined length, the substrate material clamp moves downwardly and slowly approaches the base by a driving action of the driving member. Since the flattening member is disposed on the lower surface of the substrate material clamp, when the substrate material clamp approaches the base, the flattening member is first contacted with the substrate material on the upper surface of the base; and as a distance between the substrate material clamp and the base is gradually reduced, two ends of the flattening member extend outwardly, respectively, and generate a back force to the substrate material in contact with the flattening member. In this way, the curled substrate material is flattened until the flattening member completely fits and compresses the surface of the substrate material. After the substrate material is compressed, the upper cutter device approaches to the lower cutter device mounted on the base to complete the cutting of the substrate material.

### (3) Advantageous effects

In the apparatus for cutting substrate material of the present disclosure, a clamp having a flattening member is designed. When the substrate material is transported to the base and reaches a predetermined length, the substrate material clamp approaches the base, and with the distance between the substrate material clamp and the base gradually reduces, two ends of the flattening member contact the substrate material and extend outwardly, respectively, so as to generate a back force to the substrate material in contact with the flattening member; therefore the curled substrate material is flattened and compacted. Then, the upper cutter device is driven to approach to the lower cutter device mounted on the base to complete the cutting of the substrate material. By using the flattening member of the substrate material clamp, a flat substrate material with a predetermined size is obtained. On the one hand, it meets the standardization requirements of the production line; and on the other hand, it improves the aesthetics of the substrate material and the cutting quality, prevents the occurrence of wrinkles and accumulation parts, and thus it provides the guarantee for the processing quality of the subsequent production process and the power generation performance of the substrate material, as well as the electrical conductivity of the finished battery.

### BRIEF DESCRIPTION OF THE DRAWINGS

Fig. 1 is a structural schematic diagram of a cutting machine in the related art.
Fig. 2-1 and Fig. 2-2 schematically illustrate a structure of a lower surface of a clamp in the related art.
Fig. 3 is a structural schematic diagram of an apparatus for cutting substrate material according to an embodiment of the present disclosure.
Fig. 4 is a structural schematic diagram of a substrate material clamp according to an embodiment of the present disclosure.
Fig. 5 is a structural schematic diagram of a substrate material clamp according to another embodiment of the present disclosure.
Fig. 6 is a bottom view of a clamp body according to an embodiment of the present disclosure.
Fig. 7 is a structural schematic diagram of a flattening member according to an embodiment of the present disclosure.
Fig. 8 is a structural schematic diagram of a flattening member according to another embodiment of the present disclosure.
Fig. 9 is a schematic diagram of a flattening member and a substrate material according to an embodiment of the present disclosure.
Fig. 10 shows an example of a flattening member according to the present disclosure.

### Reference numerals:

1: mounting frame; 11: mounting plate; 12: cutter mounting plate; 13: linear slide rail; 14: clamp support device; 2: base; 3: upper cutter device; 4: lower cutter device; 5: slider rail; 6: substrate material clamp; 6-1: flattening member; 61: first flattening member; 62: second flattening member; 63: joint; 64: flattening layer; 65: first flattening layer; 66: second flattening layer; 6-2: clamp body; 7: driving member; 71: driving member mounting support plate; 72: bottom end rod; 8: substrate material; 9: clamp.

### DETAILED DESCRIPTION

In order to clarify the purposes, technical solutions, and advantages of the present disclosure, the present disclosure will be further described in detail below with reference to the embodiments and the accompanying drawings. It is to be understood that the description is only illustrative, and is not intended to limit the scope of the disclosure. In addition, descriptions of well-known structures and techniques are omitted in the following description in order to avoid unnecessarily obscuring the concept of the present disclosure.

The structural schematic diagrams in accordance with the embodiments of the present disclosure are shown in the accompanying drawings. The drawings are not drawn to scale, and for clarity, some details are exaggerated and some details may be omitted.

It is apparent that the described embodiments are a part of the embodiments of the present disclosure, rather than all of them. All other embodiments obtained by a person of ordinary skill in the art based on the embodiments of the present disclosure without the inventive labor belong to the protection scope of the present disclosure.

In the description of the present disclosure, it is to be noted that the terms "first", "second", and "third" are used for depiction only, and are not to be construed as indicating or implying relative importance.

Further, the technical features involved in different embodiments of the present disclosure described below may be combined with each other as long as there is no conflict.

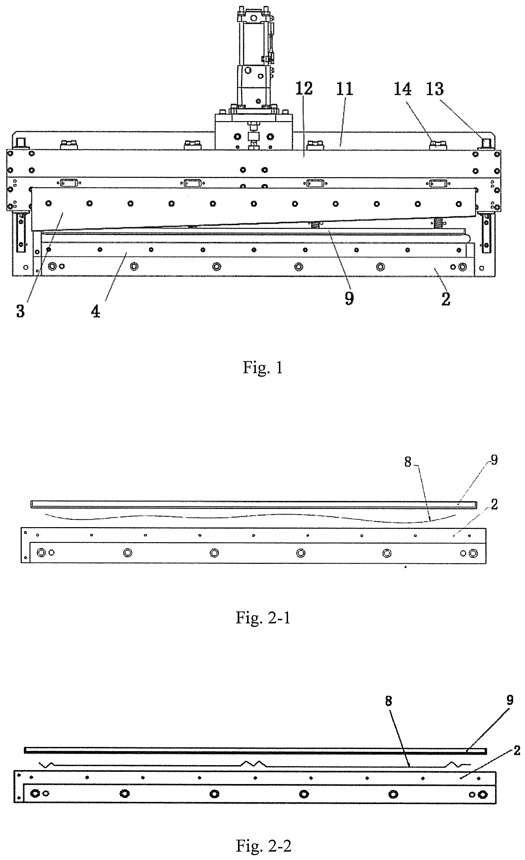

Fig. 1 is a structural schematic diagram of a cutting machine in the related art; and Fig. 2-1 and Fig. 2-2 schematically illustrate the structure of the lower surface of the clamp in the related art.

The process pipeline of the substrate material, such as the substrate material 8 of the battery chip, is as follows: the substrate material needs to be coated in a coating machine first, and then the coated substrate material 8 is cut to a predetermined size. Since heating is required in the coating machine, and the substrate material 8 is very thin, the substrate material 8 after coating is liable to be curved. The cutting machine shown in Fig. 1 has a clamp 9 which is usually made of an aluminum alloy plate, and a rubber bar is provided on a pressing surface of the aluminum alloy plate to reduce the impact force. However, an indentation is formed on the surface of the substrate material 8 when the clamp 9 is pressed down. When the substrate material 8 is transferred to a predetermined length, on the one hand, the heating of the substrate material 8 in the previous process causes the substrate material 8 to curl (see Fig. 2-1); and on the other hand, due to the operation of the cutting machine, the body of the cutting machine will vibrate, and then the substrate material 8 located on the base 2 vibrate too, so that after the pressing of the clamp 9, the substrate material 8 wrinkles or forms a pile at the depressed location (see Fig. 2-2). Meanwhile, under the action of the rubber bar on the lower surface of the aluminum alloy plate of the clamp 9 shown in Fig. 2-1 and Fig. 2-2, the substrate material 8 also has a certain indentation, which affects the power generation performance of the substrate material 8 and the subsequent processing of the battery chip.

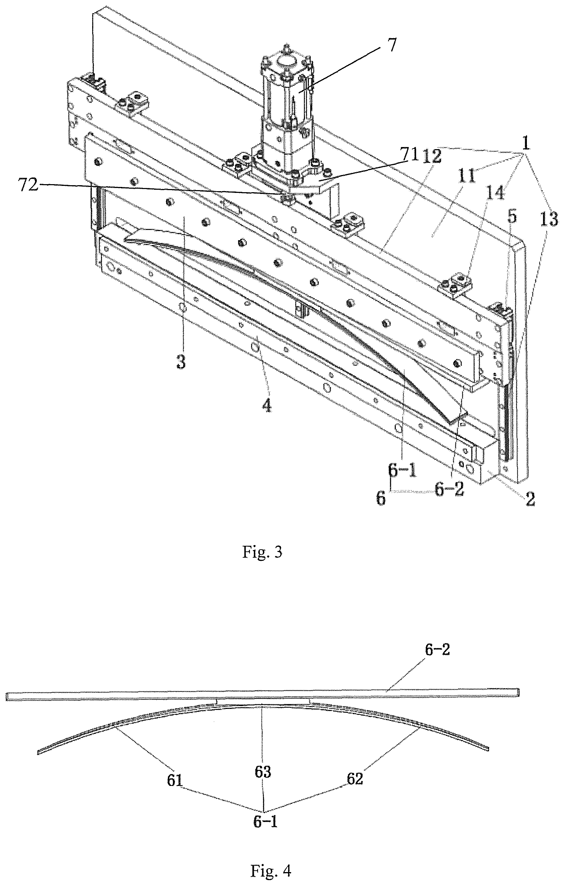

Fig. 3 is a structural schematic diagram of an apparatus for cutting substrate material according to an embodiment of the present disclosure.

According to an embodiment of the present disclosure, there is provided an apparatus for cutting substrate material. As shown in Fig. 3, the apparatus includes: a mounting frame 1; and a base 2 mounted to the mounting frame 1; wherein the mounting frame 1 is provided with an upper cutter device 3, the upper cutter device 3 is connected to the driving member 7; the upper cutter device 3 moves to approach or away from the base 2 by the driving action of the driving member 7; the upper cutter device 3 is further provided with a substrate material clamp 6; the substrate material clamp 6 may also move toward or away from the base 2 under the driving action of the driving member 7; and the lower surface of the substrate material clamp 6 is provided with a flattening member 6-1.

In an alternative embodiment, the apparatus shown in Fig. 3 further includes a lower cutter device 4; the lower cutter device 4 is disposed on the base 2 and is disposed opposite to the upper cutter device 3; and the driving member 7 drives the upper cutter device 3 to approach to or away from the lower cutter device 4. In the present embodiment, the driving member 7 may employ a cylinder, but is not limited to the cylinder. All the devices capable of providing power, driving the upper cutter device 3 to approach to or away from the lower cutter device 4 and driving the substrate material clamp 6 to approach to or away from the base 2 are within the scope of protection of this application. It should be noted that the connection manner in the embodiment is a detachable connection method, such as, screwing, pinning, and snapping, but is not limited to the above manners. The connection manner may also be adhesive bonding.

In an alternative embodiment, as shown in Fig. 3, the mounting frame 1 includes: a mounting plate 11 and a cutter mounting plate 12 connected to the mounting plate 11; wherein the mounting plate 11 includes a first connecting plate, a second connecting plate, a third connecting plate and a fourth connecting plate, which are connected end to end in sequence; the first connecting plate and the third connecting plate are arranged in parallel with each other, and are respectively perpendicular to the horizontal plane, and the second connecting plate and the fourth connecting plate are arranged in parallel with each other and are respectively perpendicular to the horizontal plane, which form a structure of " 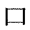 " shape. The first connecting plate and the third connecting plate are perpendicular to the horizontal plane means: the planes where the largest surfaces of the two connecting plates are located are perpendicular to the horizontal plane; and the second connecting plate and the fourth connecting plate are respectively parallel to the horizontal plane means: the planes where the largest surfaces of the two connecting plates are located are perpendicular to the horizontal plane.

The mounting plate 11 further includes at least two linear slide rails 13 respectively disposed on the surfaces of the first connecting plate and the third connecting plate. Correspondingly, the cutter mounting plate 12 includes at least two slider guide rails 5. The slider guide rails 5 and the linear slide rails 13 are engaged with each other, and the cutter mounting plate 12 is coupled to the mounting plate 11 and may slide up and down along the linear slide rails 13. The upper cutter device 3 is fixedly mounted on the cutter mounting plate 12, so as to slide along the linear slide rails 13 by the driving of the drive cutter 7 and the cutter mounting plate 12. The cutter mounting plate 12 is designed as a right angle trapezoid with one side of the right angle waist conforming to the longitudinal direction of the mounting plate 11, and the waist opposite the right angle waist is opposed to the lower cutter device 4 so that a scissor shear is formed after the upper cutter device 3 approaches to the cutter device 4.

As shown in Fig. 3, at least one clamp support device 14 is mounted on the top end of the cutter mounting plate 12 for supporting the substrate material clamp 6. The clamp supporting device 14 is fixed to the cutter mounting plate 12 by, for example, a screw connection. The driving member 7 is disposed between the cutter mounting plate 12 and the mounting plate 11, and the driving member 7 is fixed to the mounting plate 11 by a driving member mounting support plate 71. A bottom end rod 72 of the driving member 7 is a movable end, and the driving member 7 is connected to an upper floating joint of the cutter mounting plate 12 through the bottom end rod 72 for driving the cutter mounting plate 12 to move. When the cutter mounting plate 12 moves downward by the driving of the driving member 7, the clamp supporting device 14 also moves downward together with the cutter mounting plate 12, thereby the substrate material clamp 6 presses down. It should be noted that a lower end of the clamp supporting device 14 and the substrate material clamp 6 are connected by a spring. The substrate material clamp 6 compresses the substrate material 8 by the action of the driving member 7, and then the cutter mounting plate 12 drives the upper cutter device 3 to slide toward the base 2. During this process, the spring is compressed to buffer an impact of the cutter mounting plate 12 on the substrate material clamp 6 that has been fixed.

It should be noted that the connection manner in this embodiment may adopt a detachable connection manner, for example, screwing, pinning, and snapping, but is not limited to the above, and the connection manner may also be adhesive bonding.

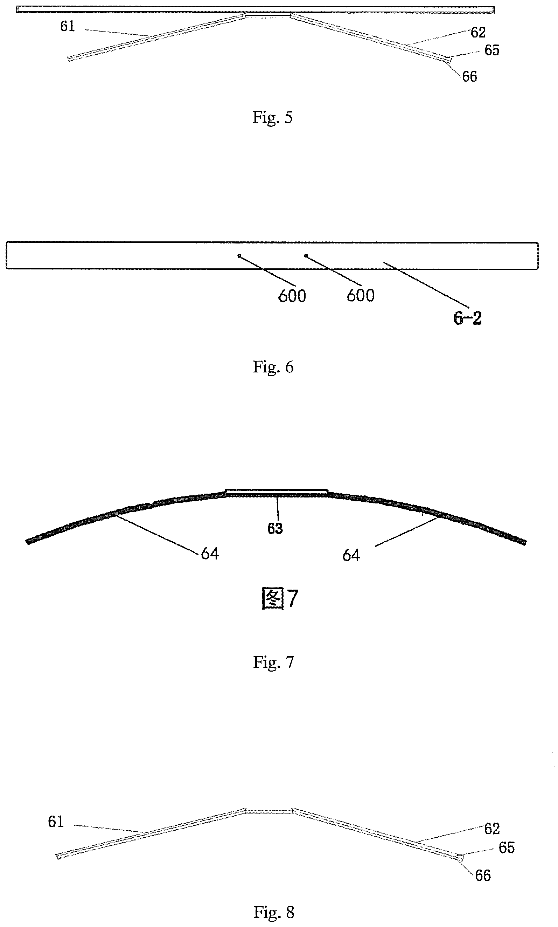

Fig. 4 is a structural schematic diagram of a substrate material clamp according to an embodiment of the present disclosure; Fig. 5 is a structural schematic diagram of a substrate material clamp according to another embodiment of the present disclosure; and Fig. 6 is a bottom view of a clamp body according to an embodiment of the present disclosure.

In an alternative embodiment, as shown in Fig. 4 and Fig. 5, the flattening member 6-1 includes a first flattening member 61 and a second flattening member 62; the first flattening member 61 and the second flattening member 62 are movably connected, and a joint 63 of the first flattening member 61 and the second flattening member 62 is coupled to a clamp body 6-2 of the substrate material clamp 6.

In the present embodiment, the first flattening member 61 and the second flattening member 62 may be integrally connected to each other, or may be two parts connected by the joint 63, and the first flattening member 61 and the second flattening member 62 may move relative to the joint 63. The first flattening member 61 and the second flattening member 62 both have a strip structure, but are not limited to the strip structure, as long as widths of both the first flattening member 61 and the second flattening member 62 are matched with a width of the clamp body 6-2. Specifically, the widths of both the first flattening member 61 and the second flattening member 62 may be equal to the width of the clamp body 6-2, or may be smaller than the width of the clamp body 6-2 or larger than the width of the clamp body 6-2, and preferably, the widths of both the first flattening member 61 and the second flattening member 62 are equal to the width of the clamp body 6-2. The joint 63 of the first flattening member 61 and the second flattening member 62 is connected to the clamp body 6-2, and the connection manner is preferably a detachable connection manner, for example, screwing, pinning, and snapping, but is not limited to the above enumeration, and the connection manner may also be adhesive bonding. For example, as shown in Fig. 6, the joint 63 may be fixedly coupled to the clamp body 6-2 of the substrate material clamp 6 by passing a screw through a mounting hole 600.

In an alternative embodiment, the joint 63 has a length of 100-200 mm, preferably 150-200 mm, more preferably 180-200 mm, such as 180 mm, 185 mm, 190 mm, 195 mm or 200 mm, wherein the optimum value is 200 mm. Since the flattening member 6-1 is connected to the clamp body 6-2 only through the joint 63, and the flattening member 6-1 itself has a certain gravity, if the joint 63 is connected to the clamp body 6-2 only in the form of a point connection, it is easy to cause damage to the flattening member 6-1, and shorten the service life. By appropriately controlling the length of the joint 63, a certain protective effect may be provided to the flattening member 6-1, and the service life is prolonged. On the other hand, an amount of droop at the lowest end of the flattening member 6-1 may be controlled such that when the two lowest ends are in contact with the substrate material 8, a sufficiently large backing force is generated to flatten the substrate material 8.

Fig. 4 is a structural schematic diagram of a substrate material clamp according to an embodiment of the present disclosure.

In an alternative embodiment, as shown in Fig. 4, the first flattening member 61 and the second flattening member 62 have an arc shape.

In this embodiment, one end of the first flattening member 61 connected to the joint 63 extends outwardly to an end to be an arc shape, and an end of the second flattening member 62 connected to the joint 63 extends outward to an end to be an arc shape, the two arc shapes being preferably symmetrical. In the present embodiment, the lengths of the two arc shapes of the first flattening member 61 and the second flattening member 62 are 400-500 mm, preferably 400-410 mm, more preferably 400-405 mm, such as 400 mm, 401 mm, 402 mm, 403 mm, 404 mm or 405 mm, and the optimum value is 405 mm.

Fig. 5 is a structural schematic diagram of a substrate material clamp according to another embodiment of the present disclosure.

In an alternative embodiment, as shown in Fig. 5, inner sides of the first flattening member 61 and the second flattening member 62 are disposed in a linear shape.

In the present embodiment, the joint 63 may be a point connection, that is, the joint 63 is a point. At this time, the lengths of the first flattening member 61 and the second flattening member 62 are both 495-500 mm, for example, 495 mm, 496 mm, 497 mm, 498 mm, 499 mm, or 500 mm. It is preferably 496 mm, 497 mm, and 498 mm. The point connection of the joint 63 may have a width of 5 mm to 10 mm, for example, 5 mm, 6 mm, 7 mm, 8 mm, 9 mm or 10 mm. In one case, the first flattening member 61 and the second flattening member 62 are in the shape of a straight line, and are entirely made of an elastic material; and in another case, the first flattening member 61 and the second flattening member 62 are in the shape of a straight line, and the ends thereof (the ends at which the first flattening member 61 and the second flattening member 62 meet the substrate material 8) are made of an elastic material. The former case is preferable, but the present disclosure is not limited to the above examples.

In an alternative embodiment, the first flattening member 61 and the second flattening member 62 are each provided with a rough inner surface.

In the present embodiment, the inner surface refers to one surface facing the base 2. By using the rough inner surface, when the substrate material clamp 6 presses down the substrate material 8 on the base 2, the inner surface contacts the substrate material 8 and applies a certain amount of friction to the substrate material 8 to fix the position of the substrate material 8, thereby avoiding that the substrate material 8 is biased by the upper cutter device 3 and the lower cutter device 4 during cutting, and ensuring the accuracy of the size of the substrate material 8.

Fig. 7 is a structural schematic diagram of a flattening member according to an embodiment of the present disclosure.

In an alternative embodiment, as shown in Fig. 7, the flattening member 6-1 includes at least one flattening layer 64; and a surface of the flattening layer 64 facing the base 2 is disposed as a rough surface.

In this embodiment, the flattening member 6-1 may be an integral strip structure composed of one flattening layer 64, and a surface of the flattening layer 64 opposite to the inner surface facing the base 2 may be adhered to the lower surface of the clamp body 6-2 by adhesive bonding. The purpose of adopting the rough surface as the surface facing the base 2 is as follows: when the substrate material clamp 6 presses down the substrate material 8 on the base 2, the inner surface contacts the substrate material 8 and applies a certain amount of friction to the substrate material 8 to fix the position of the substrate material 8, in this way, it may be avoided that the substrate material 8 is biased by the upper cutter device 3 and the lower cutter device 4 during cutting, and the accuracy of the size of the substrate material 8 can be ensured.

Fig. 8 is a structural schematic diagram of a flattening member according to another embodiment of the present disclosure.

In an alternative embodiment, as shown in Fig. 8, the flattening member 6-1 includes a first flattening layer 65 and a second flattening layer 66 that are interconnected; and the second flattening layer 66 faces the base 2.

In this embodiment, the first flattening layer 65 may be made of a spring material, such as silicon manganese spring steel (60Si2Mn), silicon chrome spring steel (60Si2CrA or 60Si2CrVA) or 65 manganese spring steel, 70 manganese spring steel material, preferably silicon manganese spring steel (60Si2Mn), and the thickness of the first flattening layer 65 may be, for example, 3 mm. Through the design of the first flattening layer 65, the substrate material may be expanded and flattened when the substrate material clamp 6 presses the substrate material, and the substrate material restores to its original state when the substrate material clamp 6 is ascending. The second flattening layer 66 may be made of a rough and antiskid material such as PU, PE, PP, PVC, etc., preferably a PU material, and the thickness of the second flattening layer 66 may be, for example, 5 mm. Since the PU has a larger friction coefficient compared with materials such as PE, PP, PVC, etc., the fixing effect of the substrate material 8 is better, and the precision of the cutting size of the substrate material 8 can be improved.

It should be noted that PU is polyurethane material, and is the abbreviation of polyurethane; PE is the abbreviation of polyethylene; PP is the polypropylene; and PVC is Polyvinyl chloride.

In an alternative embodiment, a distance between a lowest end of the flattening member 6-1 and an upper surface of the base 2 is 20-25 mm.

In the present embodiment, the distance between the lowest end of the flattening member 6-1 and the upper surface of the base 2 is set to 20-25 mm, for example, 20 mm, 21 mm, 22 mm, 23 mm, 24 mm or 25 mm.

In an alternative embodiment, the distance between the lowest end of the flattening member 6-1 and a horizontal plane of the joint 63 is 90-110 mm, preferably 95-105 mm, and most preferably 100 mm.

In the above two embodiments, the flattening member 6-1 is designed such that the distance between the lowest end thereof and the joint 63 and the distance between the lowest end thereof and the base 2 are within the predetermined range of the above embodiment, therefore the two lowest ends of the flattening member 6-1 may contact with the upper surface of the substrate material 8 during the pressing process, a backward and outward force is formed at the contact point, and the substrate material 8 with a fixed size may be flattened under this force.

In an alternative embodiment, two ends of the flattening member 6-1 are extendable outwardly by 10-20 mm, respectively.

In the present embodiment, when both ends of the flattening member 6-1 are respectively extended outward, the flattening member 6-1 forms a linear strip structure which is in close contact with the lower surface of the substrate material 8, and the total length of the flattening member 6-1 is adapted to the width of the substrate material 8, for example, the total length of the flattening member 6-1 is equal to the width of the substrate material 8, or may be greater than the width of the substrate material 8.

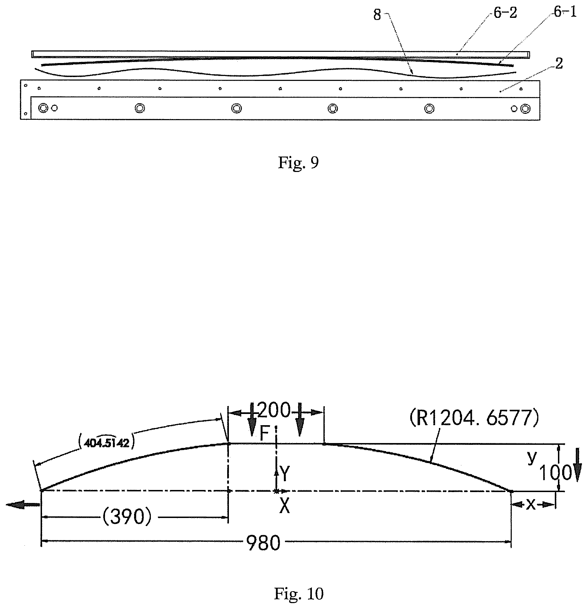

Fig. 9 is a schematic diagram of a flattening member and a substrate material according to an embodiment of the present disclosure. As shown in Fig. 9, the substrate material 8 is placed on the base 2, and the flattening members 6-1 and 6-2 are above the substrate material 8.

### First embodiment

The first embodiment of the present disclosure provides an apparatus for cutting substrate material, including: a mounting frame 1; a base 2 mounted to the mounting frame; an upper cutter device 3 disposed on the mounting frame 1; a substrate material clamp 6 disposed on the upper cutter device 3 and being used to clamp the substrate material, wherein the substrate material clamp 6 includes a clamp body 6-2 and a flattening member 6-1 connected to the clamp body, and the flattening member 6-1 is used to flatten the substrate material.

Optionally, the flattening member 6-1 includes a first flattening member 61 and a second flattening member 62; the first flattening member 61 and the second flattening member 62 are movably connected, and a joint 63 of the first flattening member 61 and the second flattening member 62 is connected to the clamp body 6-2.

Optionally, the first flattening member 61 and the second flattening member 62 are arc-shaped.

Optionally, inner sides of the first flattening member 61 and the second flattening member 62 are set as a linear shape.

Optionally, the first flattening member 61 and the second flattening member 62 are respectively provided with a rough inner surface.

Optionally, the flattening member 6-1 includes at least one flattening layer 64 having elasticity.

Optionally, the flattening member 6-1 includes a first flattening layer 65 and a second flattening layer 66 connected to each other; and the second flattening layer 66 faces the base 2.

Optionally, a distance between a lowest end of the flattening member 6-1 and an upper surface of the base 2 is 20-25 mm, and a distance between the joint 63 of the flattening member 6-1 and the upper surface of the base 2 is 120-125 mm.

Optionally, both ends of the flattening member 6-1 are extendable outward by 10-20 mm, respectively.

Optionally, the apparatus for cutting substrate material further includes: a driving member 7 connected to the upper cutter device 3, and the upper cutter device 3 and substrate material clamp 6 are driven by the driving member 7 to close to or be away from the base 2.

Optionally, the apparatus for cutting substrate material further includes: a lower cutter device 4; the lower cutter device 4 is disposed on the base 2 and is opposite to the upper cutter device 3; and the driving member 7 drives the upper cutter device 3 to approach to or away from the lower cutter device 4.

Optionally, a length of the joint 63 is 100-200 mm.

Optionally, entire bodies or ends of the first flattening member 61 and the second flattening member 62 are made of an elastic material.

Optionally, lengths of the arcs of the first flattening member 61 and the second flattening member 62 are both 400-500 mm.

Optionally, lengths of the flattening member 61 and the second flattening member 62 are both 495-500 mm.

One specific example of the flattening member according to the present disclosure will be described below with reference to Fig. 10.

The parameters used in this example are as follows:
Material: the first flattening layer is manganese spring steel 60Si2Mn (tensile strength σb: ≥ 1274 MPa, yield strength σs: ≥ 1176 MPa), and the second flattening layer is PU polyurethane;
Pressure: F = 1000 N, displacement distance: x = 14 mm, y = 100 mm.

As shown in Fig. 10, during the pressing of the substrate material clamp, the flattening member produces an action of unwinding the substrate material to flatten the substrate material, so as to prevent the substrate material from wrinkling when being pressed. Specifically, firstly, the edge of the substrate material is pressed, and then the flattening member is pressed down in the -Y direction, and the flattening member is deformed to expand the edge of the substrate material in the X direction and the -X direction, and finally the flattening member is leveled, and then the entire substrate material is flattened.

It should be noted that in the following, the substrate material clamp 6 is a part of the apparatus for cutting substrate material, which has been described in the above embodiment, and will not be described herein.

According to another embodiment of the present disclosure, there is provided a substrate material clamp 6, including: a clamp body 6-2 and a flattening member 6-1; wherein the flattening member 6-1 is disposed at a lower surface of the clamp body 6-2.

In an alternative embodiment, the flattening member 6-1 includes a first flattening member 61 and a second flattening member 62; the first flattening member 61 and the second flattening member 62 are movably connected, and a joint 63 of the first flattening member 61 and the second flattening member 62 is connected to the clamp body 6-2.

In an alternative embodiment, the first flattening member 61 and the second flattening member 62 are arc-shaped.

In an alternative embodiment, inner sides of the first flattening member 61 and the second flattening member 62 are set as a linear shape.

In an alternative embodiment, the first flattening member 61 and the second flattening member 62 are respectively provided with a rough inner surface.

In an alternative embodiment, the flattening member 6-1 includes at least one flattening layer 64; and a surface of the flattening layer 64 facing the substrate material 8 is disposed as a rough surface.

In an alternative embodiment, the flattening member 6-1 includes a first elastic layer 65 and a second flattening layer 66 that are interconnected; and the first flattening layer 65 is adjacent to the clamp body 6-2.

In an alternative embodiment,, a distance between a lowest end of the flattening member 6-1 and the upper surface of the base 2 is 20-25 mm.

In an alternative embodiment, two ends the flattening member 6-1 are extendable outwardly by 10-20 mm, respectively.

The present disclosure is directed to protect an apparatus for cutting substrate material and a clamp. By designing a clamp having a flattening member 6-1, when the substrate material 8 is transported to the base 2 and reaches a predetermined length, the substrate material clamp 6 approaches the base 2, and as the distance between the substrate material clamp 6 and the base 2 gradually decreases, both ends of the flattening member 6-1 contact the substrate material 8 and extend outwardly, respectively, and apply a back force to the substrate material 8 contacting the flattening member 6-1. In this way, the curled substrate material 8 is flattened and compacted. Then, the upper cutter device 3 is driven to approach the lower cutter device 4 mounted on the base 2 to complete the cutting of the substrate material 8. The use of the flattening member 6-1 of the substrate material clamp 6 results in a flat substrate material 8 with a predetermined size. On the one hand, the standardization requirements of the production line are satisfied; and on the other hand, the aesthetics and cutting quality of the substrate material 8 are improved. In addition, the formation of wrinkles and accumulation sites may be avoided, thereby ensuring the processing quality of the subsequent production process, the power generation performance of the substrate material 8, and the electrical conductivity of the finished battery.

It should be understood that the above-described embodiments of the present disclosure are used only for illustration or explaining the principle of the present disclosure, rather than restricting the present disclosure. Therefore, any modifications, equivalents, improvements, etc., which are made without departing from the spirit and scope of the present disclosure, are intended to be included within the protection scope of the present disclosure. Rather, the appended claims are intended to cover all changes and modifications that come within the scope and range of the appended claims, or equivalents thereof.

## Claims

1. An apparatus for cutting substrate material, comprising:
a mounting frame (1);
a base (2) mounted to the mounting frame (1);
an upper cutter device (3) disposed on the mounting frame (1); and
a substrate material clamp (6) disposed on the upper cutter device (3) and configured to clamp the substrate material, the substrate material clamp (6) comprising a clamp body (6-2) and a flattening member (6-1) connected to the clamp body, and the flattening member (6-1) being configured to flatten the substrate material.

2. The apparatus according to claim 1, wherein the flattening member (6-1) comprises a first flattening member (61) and a second flattening member (62);
the first flattening member (61) and the second flattening member (62) are movably connected, and a joint (63) of the first flattening member (61) and the second flattening member (62) is connected to the clamp body (6-2).

3. The apparatus according to claim 2, wherein the first flattening member (61) and the second flattening member (62) are arc-shaped.

4. The apparatus according to claim 2, wherein inner sides of the first flattening member (61) and the second flattening member (62) are set as a linear shape.

5. The apparatus according to any one of claims 2 to 4, wherein the first flattening member (61) and the second flattening member (62) are respectively provided with a rough inner surface.

6. The apparatus according to any one of claims 1 to 5, wherein the flattening member (6-1) comprises at least one flattening layer (64) having elasticity.

7. The apparatus according to claim 6, wherein the flattening member (6-1) comprises a first flattening layer (65) and a second flattening layer (66) connected to each other; and
the second flattening layer (66) faces the base (2).

8. The apparatus according to any one of claims 2 to 5, wherein a distance between a lowest end of the flattening member (6-1) and an upper surface of the base (2) is 20-25 mm, and a distance between the joint (63) of the flattening member (6-1) and the upper surface of the base (2) is 120-125 mm.

9. The apparatus according to any one of claims 1 to 8, wherein both ends of the flattening member (6-1) are extendable outward by 10-20 mm, respectively.

10. The apparatus according to any one of claims 1 to 9, further comprising a driving member (7) connected to the upper cutter device (3), wherein the upper cutter device (3) and the substrate material clamp (6) are driven by the driving member (7) to approach or away from the base (2).

11. The apparatus according to claims 10, further comprising a lower cutter device (4);
wherein the lower cutter device (4) is disposed on the base (2) and is opposite to the upper cutter device (3); and
the driving member (7) drives the upper cutter device (3) to approach or away from the lower cutter device (4).

12. The apparatus according to claim 2 or 8, wherein a length of the joint (63) is 100-200 mm.

13. The apparatus according to claim 3 or 4, wherein entire bodies of the first flattening member (61) and the second flattening member (62) or ends of the first flattening member (61) and the second flattening member (62) are made of an elastic material.

14. The apparatus according to claim 3, wherein lengths of the arcs of the first flattening member (61) and the second flattening member (62) are both 400-500 mm.

15. The apparatus according to claim 4, wherein lengths of the first flattening member (61) and the second flattening member (62) are both 495-500 mm.
